(19) Europäisches Patentamt
European Patent Office
Office européen des brevets

(11) Publication number : **0 463 769 A2**

(12) # EUROPEAN PATENT APPLICATION

(21) Application number : **91305298.1**

(22) Date of filing : **12.06.91**

(51) Int. Cl.$^5$ : **C08G 64/00,** C08L 69/00, C09D 5/00

(30) Priority : **21.06.90 GB 9013838**

(43) Date of publication of application : **02.01.92 Bulletin 92/01**

(84) Designated Contracting States : **DE ES FR GB IT NL SE**

(71) Applicant : **COOKSON GROUP plc**
**130 Wood Street**
**London EC2V 6EQ (GB)**

(72) Inventor : **Clifford, John Francis**
**Burn House, Brookstones**
**Sydenham, Oxfordshire OX9 4LY (GB)**
Inventor : **Wagland, Alison Mary**
**9 Oatlands Road**
**Oxfordshire OX2 0EU (GB)**
Inventor : **Collister, Brian John**
**161 Thorney Leys**
**Witney, Oxfordshire OX8 7YL (GB)**

(74) Representative : **Allard, Susan Joyce et al**
**BOULT, WADE & TENNANT, 27 Furnival Street**
**London EC4A 1PQ (GB)**

(54) **Binder system based on thermally depolymerisable polycarbonate.**

(57) A composition which comprises at least one powdered or flaked material admixed with at least one thermally depolymerisable polycarbonate, or a solution thereof, the thermally depolymerisable polycarbonate containing the repeating units

$$(R^1-O-\overset{\overset{O}{\|}}{C}-O-R^2-O-\overset{\overset{O}{\|}}{C}-O)$$

where $R^1$ and $R^2$ are the same or different and each independently represents a hydrocarbon group containing from 4 to 30 carbon atoms, the said group having a tertiary carbon atom, an allylic, propargylic or benzylic group attached directly to at least one oxygen atom.

EP 0 463 769 A2

The present invention relates to a novel binder system and, in particular, to the use of a thermally depolymerisable polymer as a binder for powdered glass, ceramic or metallic materials, and as a viscosity control agent in paste formulations.

Thermally depolymerisable polycarbonates have been described by F.M. Houlihan, F. Bouchard, J.M.J. Frechet and G.G. Wilson in Macromolecules 1986, 19, 13-19. The materials which are described are tertiary copolycarbonates containing a tertiary diol structure which were prepared by using a solid-liquid phase-transfer-catalyzed polycondensation of the bis(carbonylimidazolide) of 2,5-dimethyl-2,5-hexanediol with various other diols in the presence of finely powdered potassium carbonate. These copolycarbonates decompose cleanly upon heating to about 200°C with liberation of volatile materials, leaving no solid residue.

We have now surprisingly found that thermally depolymerisable polycarbonates can be used as binders for a variety of powdered materials, and as shear thinning viscosity control agents in paste formulations. Furthermore, as they depolymerise rather than pyrolyse, they do not require the presence of oxygen and can be processed in an inert atmosphere such as nitrogen.

Accordingly, the present invention provides a composition which comprises at least one powdered material admixed with at least one thermally depolymerisable polycarbonate, or a solution thereof, the thermally depolymerisable polycarbonate containing the repeating units

$$(R^1-O-\overset{\overset{O}{||}}{C}-O-R^2-O-\overset{\overset{O}{||}}{C}-O)$$

where $R^1$ and $R^2$ are the same or different and each independently represents a hydrocarbon group containing from 4 to 30 carbon atoms, the said group having a tertiary carbon atom, an allylic, propargylic or benzylic group attached directly to at least one oxygen atom.

The thermally depolymerisable polycarbonates used in the present invention may be produced by the condensation reaction between a diol, or a mixture of diols, and phosgene or a phosgene analogue such as 1,1′-carbonyldiimidazole.

The polycarbonates owe their thermal lability to the structure of the diols which are used in their production. The diols generally possess tertiary benzylic, allylic or propargylic groups bonded to the hydroxyl functional groups in the diols. Examples of diols which may be used in the preparation of the polycarbonates used in the present invention include m-benzenedimethanol, 2,5-dimethyl-2,5-hexanediol, 2-cyclohexen-1,4-diol, 2-butyne-1,4-diol, p-bis(1-hydroxyethyl)benzene and α,α,α′,α′-tetramethyl-1,4-benzenedimethanol, or a mixture of two or more thereof.

The thermally depolymerisable polycarbonates may be used, in accordance with the present invention, as binders for a wide range of powdered materials such as powdered glass, powdered ceramic materials or powdered or flaked metals or alloys, or mixtures thereof. The amount of the powdered material which. is mixed with the binder will depend upon the intended end use of the composition so formed. For example, if the polycarbonate is to be used in a paste system, such as a solder paste, glass paste or a hybrid thick film or similar electrical paste such as indium tin oxide paste, the quantity of powdered material in the composition will generally be in the range of from 50 to 98% by weight based on the total dry weight of the composition depending on the bulk density of the solids, and the specific gravity of both solids and liquids. However, when the thermally depolymerisable polycarbonate is used as a binder/pressing aid for a powdered ceramic materiel the powdered ceramic material will generally be present in the composition in an amount of from 80 to 99.999% by weight based on the total dry weight of the composition, and preferably less than 90% by weight.

The thermally depolymerisable polycarbonate used in the present invention may be used in combination with other binders, such as ethyl cellulose or derivatives thereof in relatively small amounts. The use of other binders, in combination with the thermally depolymerisable polycarbonate, may be beneficial in controlling the rheology or other properties of the mixture.

It will be appreciated that for some applications it will be necessary to dissolve the thermally depolymerisable polymer in a solvent, or a mixture of solvents, the choice of which is dependent on the application. Volatile solvents such as chloroform or 1,4-dioxane may be used when the function of the polycarbonate is to act as a pressing aid/binder. In the case of electronic pastes for silk screen printing etc., a solvent of low volatility for example a glycol ether or a derivative thereof, such as diethyleneglycol monobutyl ether acetate is preferred.

The thermally depolymerisable polycarbonates used as binders in the present invention generally decompose at a temperature in the range of 200° to 250°C. Thus, when used as a binder for a solder paste the polymer will decompose during the use of the pastes, thereby leaving minimal residues. When the thermally depolymerisable polycarbonate is used as a binder/pressing aid for a ceramic powder material the polymer will depolymerise at a temperature in the range of from 200 to 250°C, even in an inert, non oxygen containing atmosphere,

or a reduced oxygen atmosphere. This is in contrast to many binders which have to be burnt out in an oxygen atmosphere and is particularly important in respect of ceramic materials such as $Si_3N_4$ which are, or should if possible be, processed in an inert atmosphere, e.g. under a nitrogen blanket. Similarly, such a characteristic is also particularly desirable in the processing of nitrogen fired hybrid thick film pastes such as described in US Patents Nos. 4594181, 4600604, 4597897, 4654166 and 4537703.

It will be appreciated by those skilled in the art that it may be advantageous to use a mixture of thermally depolymerisable polycarbonates as the binder in the compositions of the invention. The use of such a mixture will provide the ability to vary the rheological properties of the binder or vehicle, the depolymerisation temperature, the depolymerisation rate, etc.

The present invention includes within its scope the use of a thermally depolymerisable polycarbonate as a binder for a powdered material, and as viscosity control agents in paste formulations.

The present invention will be further described with reference to the following non-limiting Examples in which parts and percentages are by weight, unless otherwise stated.

Designation of Materials

Polycarbonates prepared from 2,5-dimethyl-0,0'bis(1-imidazolylcarbonyl)-2,5-hexanediol and the following diols a, b, c and d were designated as polymers A, B, C and D respectively:-

| Diol | Polymer |
|---|---|
| a = 1,4-benzenedimethanol | A |
| b = 1,3-benzenedimethanol | B |
| c = 80% 1,4- and 20% 1,3-benzenedimethanol | C |
| d = 2-butyne-1,4-diol | D |

EXAMPLE 1

Using chloroform as a solvent, polymers A, B and C were combined with a silver flake and a low melting (350°C) glass powder to form a paste.

The mixing ratio for each of the three pastes was as follows:

| | |
|---|---|
| Polymer and solvent | 17 wt% |
| Glass Powder | 16 wt% |
| Silver Flake | 67 wt% |

The three pastes were applied to a number of substrate materials including alumina, black alumina, silicon wafer and zircon. The coated substrates were heated up to a temperature of 350°C.

In all cases a successful bond was made by the silver paste to the substrate. The polymers were fully removed by the heat treatment at a temperature which is lower than which can be used to fully pyrolyse conventional acrylate, cellulose and vinyl. acetate based systems. Polymers A, B and C act as commendable viscosity modifying/binding agents.

EXAMPLE 2

Polymer C as described above was used as a pressing aid/binder for very fine ultra high purity barium titanate ($BaTiO_3$- $d_{50}$ = 1.1μ, surface area 2.9 $m^2$/gm), a material which under normal circumstances will not press well, even with the addition of the common pressing aid polyvinyl alcohol (PVA).

The polymer C was dissolved initially in diethyleneglycol monobutylether acetate, to form a saturated solution and this solution was added at 3wt% to the barium titanate using excess acetone to aid mixing. The acetone was easily removed by evaporation prior to pressing the powder. The resulting dry powder was pressed into 20 mm diameter discs using a die press.

As a control, barium titanate powder without the binder addition was treated with acetone as above and pressed at approximately 4000 psi into 20 mm diameter discs for comparison.

After pressing both sets of discs were partially sintered by heating in air at 3°C per minute to 1175°C.

The discs prepared using the thermally depolymerisable polycarbonate, polymer C, were of good quality with no visible cracks. After heating the discs in air to 1175°C, no cracks were apparent.

The control discs were of a poorer quality, the barium titanate pressing badly and cracks showing around the circumference of the discs. On heating to 1175°C the edges of the discs flaked away.

EXAMPLE 3

A binder was prepared from a mixture of 7.4wt% of polymer B and 6.9% of polymer C dispersed in diethyleneglycol monobutyl ether. At room temperature the binder was a semi-solid gel and suitable as a vehicle for making solder pastes. A mixture of 10wt% of the above gel, 0.25wt% of succinic acid and 89.75wt% of a 63:37 tin-lead solder powder formed a structured paste which had a viscosity of 990 Pa s. When printed onto a ceramic substrate through a stencil and reflowed by heating in air to 215°C, a single solder ball formed as the binder decomposed and evaporated.

EXAMPLE 4

A binder was prepared from a mixture of 9wt% of polymer A and 91wt% of diethyleneglycol monobutyl ether. This was a semi-solid gel which could be liquified by vigorous stirring, but returned to a stiff paste after stirring. A mixture 10wt% of the above gel, 0.25wt% succinic acid and 89.75wt% solder powder formed a structured paste with a viscosity of 1019 Pa s. When printed and reflowed by heating in air to 215°C it performed as in Example 3.

EXAMPLE 5

A binder was prepared from 5wt% of polymer C and 95wt% of diethyleneglycol monobutyl ether and used to form a solder paste as described in Examples 3 and 4. The viscosity, measured under the same conditions was 305 Pa s. The paste performed satisfactorily on printing and reflowing by heating in air to 215°C.

EXAMPLE 6

A binder prepared from 2wt% of polymer A and 98wt% of diethyleneglycol monobutyl ether was a soft workable gel. A solder paste made as in the previous Examples had a viscosity of 64.2 Pa.s. This paste was suitable for dispensing and reflowed satisfactorily on heating in air at 215°C.

EXAMPLE 7

A binder was prepared from a mixture of 10wt% of polymer A and 20wt% of polymer D in dipropyleneglycol monomethyl ether. A paste was made from a mixture of 8.75wt% of the binder, 0.25wt% succinic acid and 91wt% of 63:37 tin-lead solder having a particle size in the range of from 25 to 45 micrometres. When the paste was printed and reflowed by heating in air to 215°C a single solder ball was formed.

EXAMPLE 8

Sealing Glass

12g of Nippon Electric Glass LS0113 (average particle size 12.5$\mu$) were mixed with 1.5g of a 0.5% solution of polymer A dissolved in diethylene glycol monobutyl ether acetate as solvent. The resulting paste was thinly spread onto the two halves of a black alumina ceramic chip carrier which were then glazed and sealed at 420°C. The resulting "cerdip" package was well adhered. Simultaneous DTA/TG thermal analysis of the sealing glass paste showed that glass and fillers had not interfered with the low temperature evolution of the polycarbonate vehicle system, the organics being removed well below the melting temperature of the glass.

EXAMPLE 9

Thick Film Conductors - as described in US 4,567,151

A batch of glass containing

| | Wt% |
|---|---|
| $Bi_2O_3$ | 81.6 |
| $SiO_2$ | 15.8 |
| PbO | 2.6 |

was mixed and melted at 1350°C in a platinium crucible. The resulting glass was ground and sieved to provide a powder having a particle size of 50% less than 2.7 micrometres as measured on a Malvern Mastersizer.

Two pastes were made having the following composition:

| | |
|---|---|
| Metal Powder* | 65 wt% |
| Glass Powder | 11 wt% |
| ZnO | 2 wt% |
| 0.5% Polymer A dissolved in diethyleneglycol monobutyl ether acetate | 22 wt% |

* either Ag/Pd 70/30 powder with a particle size of 50% less than 1 micrometre, or Ag powder with a particle size of 50% less than 1.7 micrometre.

The pastes were printed through a 325 mesh British Standard screen onto 96% alumina substrates and dried for 15 minutes at 130°C. Two firing atmospheres, air and nitrogen were tested. The firing cycle comprising a fast ramp to 200°C followed by a 5 minute dwell time at 200°C, followed by a ramp up at approximately 35°C per minute to 850°C. After a dwell of 10 minutes, the samples were cooled at approximately 55°C/minute to room temperature giving a total profile time of 50 minutes. The pastes were also fired in a nitrogen rich atmosphere to show that the polycarbonate decomposition does not require an oxygenated atmosphere. After firing the samples were tested for conductivity and all were found to give highly conductive films, possessing good adhesion to the substrate.

EXAMPLE 10

Thick Film Resistor - as decribed in US 4,597,897

A batch of glass comprising:

| | Wt% |
|---|---|
| CaO | 10.5 |
| $SiO_2$ | 40.2 |
| $Bi_2O_3$ | 25.8 |
| $Al_2O_3$ | 18.9 |
| $ZrO_2$ | 3.8 |
| $TiO_2$ | 0.8 |

was melted in a platinium crucible at 1500°C. It was quenched, ground and sieved to a particle size of 50% less than 3.4 micrometres as measured on a Malvern Mastersizer. A paste was then produced using the

polycarbonate solution of Example 8 with 94 wt% of the solids being glass and 6 wt% solids $LaB_6$.

The paste was printed, dried and fired as in Example 9, in a nitrogen atmosphere and found to give a well adhered resistive film.

The resistor paste was also tested to determine its rheological behaviour. The paste possessed the appropriate shear thinning characteristics suitable for good screen printability.

EXAMPLE 11

Tick Film Dielectric

70 wt% barium disilicate glass powder ($d_{50}$ = 3.3μ) of the following composition

| | Wt% |
|---|---|
| BaO | 40.2 |
| $SiO_2$ | 34.8 |
| $Al_2O_3$ | 3.1 |
| PbO | 16.2 |
| ZnO | 2.6 |
| $B_2O_3$ | 3.1 |

was mixed with 30% of the polycarbonate binder as described in Example 8. The paste was printed through a 325 mesh British Standard screen onto both 96% white alumina and 430 grade steel substrates, and dried and fired in air using the method of Example 9. The films produced possessed good insulating properties and good adhesion to the substrates.

EXAMPLE 12

Silver-Glass Die Attach

The following glass was melted at 750°C and fritted into water.

| | Wt% |
|---|---|
| $V_2O_5$ | 41% |
| PbO | 41% |
| ZnO | 5% |
| $Bi_2O_3$ | 10% |
| $P_2O_5$ | 3% |

This was then ground, sieved through a 38 micrometre sieve and 1.2g of the glass mixed with 8.8g of Handy and Harman silver flake 282. 2g of a 0.5% solution of Polymer A dissolved in diethylene glycol monobutyl ether acetate was added and the resulting paste used to adhere bare backed silicon die to black alumina substrates. The samples were ramped slowly to 380°C and fired for 10 minutes at peak temperature. The die were found to have adhered to the substrate.

EXAMPLE 13

10 grams of indium tin oxide (average particle size 8.0 micrometres) were added with continuous stirring to a 0.1 gram solution of Polymer A dissolved in 25 mls of chloroform.

Keeping the mixture well stirred, it was warmed slightly to slowly remove the chloroform. When dry, the mix was deaggregated by brushing through a 150 micrometre sieve.

The resultant powder was pressed into a 25 mm diameter pellet at a pressure of 55 $MNm^{-2}$ using a small

hand operated hydraulic press.

The powder pressed well giving a good intregral, faultfree, pellet with creditable "green" strength, whereas with no binder present a coherent fault-free pressed pellet could not be produced.

EXAMPLE 14

An appropriate amount of Polymer A was dissolved in excess anhydrous dichloromethane and slurried with 20gms of silicon nitride/aluminium oxynitride/$Y_2O_3$ ceramic powder mix (Syalon 102 - Vesuvius Zyalon Midlands Ltd) and the solvent removed under vacuum in a rotary evaporator to yield a series of powders with polycarbonate addition levels of:

0, 0.1, 0.5, 1.0, 2.0, 5.0, 7.5, 10.0 weight percent.

The granular coated powders were brushed through a 150μ sieve and pressed into 19mm diameter discs at approximately 80 $MNm^{-2}$ using a hand operated hydraulic press.

It was found that an addition level of 2% produced the powder with the best ceramic processing characteristics - namely, a free flowing powder which yielded defect free pressed pellets.

The organic binder was removed by heating the pellets in a nitrogen atmosphere at 30°C per hour to 500°C, holding for 1 hour and then cooling to room temperature at 60°C per hour.

This contrasts with conventional organic binders for ceramics which cannot be fully removed when fired in nitrogen.

## Claims

1. A composition which comprises at least one powdered or flaked material admixed with at least one thermally depolymerisable polycarbonate, or a solution thereof, the thermally depolymerisable polycarbonate containing the repeating units

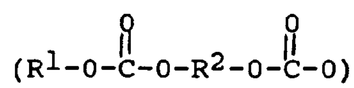

where $R^1$ and $R^2$ are the same or different and each independently represents a hydrocarbon group containing from 4 to 30 carbon atoms, the said group having a tertiary carbon atom, an allylic, propargylic or benzylic group attached directly to at least one oxygen atom.

2. A composition as claimed in claim 1 wherein the groups $R^1$ and $R^2$ in the thermally depolymerisable polycarbonate each independently represent a hydrocarbon group containing from 4 to 12 carbon atoms.

3. A composition as claimed in claim 1 or claim 2 wherein the thermally depolymerisable polycarbonate is prepared by the condensation reaction between a diol, or mixture of diols, and phosgene or a phosgene analogue.

4. A composition as claimed in claim 3 wherein the diol used in the preparation of the thermally depolymerisable polycarbonate is a diol containing a tertiary carbon atom, an allylic, propargylic or benzylic group, or a mixture of two or more such diols.

5. A composition as claimed in any one of the preceding claims wherein the powdered material is a powdered glass, powdered ceramic material or powdered metal or alloy, or a mixture thereof.

6. A composition as claimed in claim 5 wherein the powdered material is powdered glass or ceramic, or a powdered or flaked metal or alloy, or a mixture thereof, which is present in an amount of from 50 to 99.999% by weight based on the total dry weight of the composition.

7. A composition as claimed in claim 5 wherein the powdered material is a powdered ceramic material which is present in an amount of from 80 to 99.999% by weight based on the total dry weight of the composition.

8. A composition as claimed in any one of the preceding claims wherein a mixture of thermally depolymerisable polycarbonates is used.

**9.** A composition as claimed in any one of the preceding claims wherein the thermally depolymerisable polycarbonate, or a mixture thereof, is dissolved in a solvent or a mixture of solvents.

**10.** A composition as claimed in claim 9 wherein the solvent for electronic paste applications is a glycol ether, or a derivative thereof, or a mixture thereof.

**11.** The use of a thermally depolymerisable polycarbonate containing the repeating units

$$(R^1-O-\overset{O}{\overset{\|}{C}}-O-R^2-O-\overset{O}{\overset{\|}{C}}-O)$$

where $R^1$ and $R^2$ are the same or different and each independently represents a hydrocarbon group containing from 4 to 30 carbon atoms, the said group having a tertiary carbon atom, an allylic, propargylic or benzylic group attached directly to at least one oxygen atom, as a binder for a powdered material.

**12.** The use as claimed in claim 11 of a thermally depolymerisable polycarbonate as a binder for powdered glass, a powdered ceramic material, a powdered metal or alloy, or a mixture thereof.

**13.** The use of a thermally depolymerisable polycarbonate containing the repeating units

$$(R^1-O-\overset{O}{\overset{\|}{C}}-O-R^2-O-\overset{O}{\overset{\|}{C}}-O)$$

where $R^1$ and $R^2$ are the same or different and each independently represents a hydrocarbon group containing from 4 to 30 carbon atoms, the said group having a tertiary carbon atom, an allylic, propargylic or benzylic group attached directly to at least one oxygen atom, as a viscosity control agent and binder in paste formulations.

**14.** The use as claimed in claim 13 wherein the paste formulation is a solder paste, glass paste or hybrid thick film paste.